# EUROPEAN PATENT APPLICATION

(11) **EP 4 604 259 A1**
(43) Date of publication of application: **20.08.2025**
(21) Application number: 24158190.9
(22) Date of filing: 16.02.2024
(51) Int. Cl.: H01M 10/42, H01M 10/48, H01M 10/44, H01M 50/569, H01M 50/572, G01R 31/396, H02H 5/04, H02H 7/18

(54) **SYSTEM AND METHOD FOR THERMAL RUNAWAY DETECTION IN AN ELECTRICAL ENERGY STORAGE DEVICE**

(71) Applicant: VOLVO TRUCK CORPORATION, 405 08 Göteborg (SE)
(72) Inventor: SHARMA, Deepak, 412 58 Göteborg (SE); SAAD, Mohamed, 507 33 Brämhult (SE)
(74) Representative: Kransell & Wennborg KB

(57) **Abstract**

A computer system (122) for thermal runway detection in an electrical energy storage device (102) comprising: a high voltage electrical energy storage device (102), a low voltage electrical energy storage device (104), thermal runaway detection sensors (1061, 106n) configured to detect thermal runaway events in cells or modules of the high voltage electrical energy storage device, the low voltage electrical energy storage (104) supplying power to the thermal runaway detection sensors (106) via a first power supply line (108), a first switch (110) in the first power supply line (108) between the low voltage electrical energy storage device and the thermal runaway detection sensors, a second switch (114) in a power supply line between the high voltage electrical energy storage device and the thermal runaway detection sensors, the computer system comprising processing circuitry (120) configured to: in response to a first condition, open the second switch (114) and engage the first switch (110), whereby the thermal runaway detection sensors (106) are powered by the low voltage electrical energy storage device (104), and in response to a second condition, open the first switch (110) and engage the second switch (114), whereby the thermal runaway detection sensors are powered by the high voltage electrical energy storage device (102).

## Description

### TECHNICAL FIELD

The disclosure relates generally to electrical energy storage devices for vehicles. In particular aspects, the disclosure relates to a system and method for thermal runaway detection in an electrical energy storage device. The disclosure can be applied to heavy-duty vehicles, such as trucks, buses, and construction equipment, among other vehicle types. The disclosure can also be applied to marine applications and stationary applications. Although the disclosure may be described with respect to a particular vehicle, the disclosure is not restricted to any particular vehicle.

### BACKGROUND

Thermal runaway in batteries can be caused by for example, mechanical damage, electrical short-circuiting, overcharging, external heat, or internal cell defects. This condition is particularly hazardous in vehicle batteries due to the high energy content and potential for severe consequences.

Thermal runaway detection systems are often in place to detect thermal runaway signs in batteries. However, improvements in thermal runaway detection systems have been identified and are herein discussed.

### SUMMARY

According to a first aspect of the disclosure, there is provided a computer system for thermal runway detection in an electrical energy storage device comprising: a high voltage electrical energy storage device, a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, the computer system comprising processing circuitry configured to: in response to a first condition, open the second switch and engage the first switch, whereby the thermal runaway detection sensors are powered by the low voltage electrical energy storage device, and in response to a second condition, open the first switch and engage the second switch, whereby the thermal runaway detection sensors are powered by the high voltage electrical energy storage device.

The first aspect of the disclosure may seek to provide a more reliable system for thermal runaway detection. Furthermore, the first aspect may seek to lower energy consumption for thermal runaway detection. A technical benefit may include that an energy efficient system for thermal runaway detection is achieved in which functions that are not needed can be deactivated. For example, even if the high voltage electrical energy storage device is in a sleep mode, the thermal runaway detection sensors can still be operative.

Optionally in some examples, including in at least one preferred example, the first condition may be one of that the vehicle ignition is off, or the high voltage electrical energy storage device is in an at least partly in-active mode, and the second condition may be that the energy level in the low voltage electrical energy storage device is below a set limit, wherein the processing circuitry may be further configured to: when determining that the vehicle ignition is off, or the high voltage electrical energy storage device is in sleep mode, open the second switch and engage the first switch, sense the voltage level in the low voltage electrical energy storage device, and in response to that the energy level in the low voltage electrical energy storage device is below the set limit open the first switch and engage the second switch. A technical benefit may include improved availability of the thermal runaway detection sensors despite the identified conditions that may otherwise reduce the operation capability of the availability thermal runaway detection sensors.

Optionally in some examples, including in at least one preferred example, the low voltage electrical energy storage is configured to supply a voltage in the range of 5-36V. This may be considered a low voltage electrical energy storage.

Optionally in some examples, including in at least one preferred example, the processing circuitry may be a main processing circuitry, wherein the electrical energy storage device comprises multiple internal processing circuitries that each comprises integrated thermal runway sensors, wherein the main processing circuitry is configured to receive additional indications of thermal runaway events from the separate processing circuitries detected by the integrated thermal runaway sensors. A technical benefit may include that the separate processing circuitries provide improved redundancy for thermal runaway detection.

Optionally in some examples, including in at least one preferred example, the multiple internal processing circuitries of the electrical energy storage device may be powered by the low voltage electrical energy storage via a second power line connected between the low voltage electrical energy storage and the processing circuitry of the electrical energy storage device. A technical benefit may include improved redundancy due to the separate second power line to the processing circuitry.

Optionally in some examples, including in at least one preferred example, each of the internal processing circuitries may be selectively powered by the low voltage electrical energy storage and/or the high voltage electrical energy storage device. Hereby, improved redundancy for powering the processing circuitries is provided.

Optionally in some examples, including in at least one preferred example, the computer system may comprise a switching circuitry configured to switch power source for the internal processing circuitries depending on a present availability of the low voltage electrical energy storage or the high voltage electrical energy storage device. In this way, the energy consumption and redundancy of the system is further improved. That is, the switching circuitry makes sure that the internal processing circuitries are powered by the available power source.

There is further provided a vehicle comprising the computer system according to the first aspect.

Optionally in some examples, including in at least one preferred example, the vehicle may comprise the thermal runaway detection sensors configured to detect thermal runaway events in cells or modules of the high voltage electrical energy storage device, the low voltage electrical energy storage supplying power to the thermal runaway detection sensors via a first power supply line, the first switch in the first power supply line between the low voltage electrical energy storage device and the thermal runaway detection sensors, and the second switch in a power supply line between the high voltage electrical energy storage device and the thermal runaway detection sensors,

According to a second aspect of the disclosure, there is provided an electrical energy storage device comprising: a high voltage electrical energy storage device, a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, and processing circuitry configured to: in response to a first condition, open the second switch and engage the first switch, whereby the thermal runaway detection sensors are powered by the low voltage electrical energy storage device, and in response to a second condition, open the first switch and engage the second switch, whereby the thermal runaway detection sensors are powered by the high voltage electrical energy storage device.

The second aspect of the disclosure may seek to provide a more reliable system for thermal runaway detection. Furthermore, the first aspect may seek to lower energy consumption for thermal runaway detection. A technical benefit may include that an energy efficient system for thermal runaway detection is achieved in which functions that are not needed can be deactivated. For example, even if the high voltage electrical energy storage device is in a sleep mode, the thermal runaway detection sensors can still be operative. Optionally in some examples, including in at least one preferred example, the first condition may be one of that the vehicle ignition is off, or the high voltage electrical energy storage device is in an at least partly in-active mode, and the second condition may be that the energy level in the low voltage electrical energy storage device is below a set limit, wherein the processing circuitry is further configured to: when determining that the vehicle ignition is off, or the high voltage electrical energy storage device is in sleep mode, open the second switch and engage the first switch, sense the voltage level in the low voltage electrical energy storage device, and in response to that the energy level in the low voltage electrical energy storage device is below the set limit open the first switch and engage the second switch. A technical benefit may include improved availability of the thermal runaway detection sensors despite the identified conditions that may otherwise reduce the operation capability of the availability thermal runaway detection sensors.

According to a third aspect of the disclosure, there is provided a computer-implemented method for thermal runway detection in an electrical energy storage device comprising: a high voltage electrical energy storage device, a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, the method comprising: in response to a first condition, by processing circuitry of a computer system, open the second switch and engage the first switch, whereby the thermal runaway detection sensors are powered by the low voltage electrical energy storage device, and in response to a second condition, by the processing circuitry, open the first switch and engage the second switch, whereby the thermal runaway detection sensors are powered by the high voltage electrical energy storage device.

The third aspect of the disclosure may seek to provide a more reliable system for thermal runaway detection. Furthermore, the first aspect may seek to lower energy consumption for thermal runaway detection. A technical benefit may include that an energy efficient system for thermal runaway detection is achieved in which functions that are not needed can be deactivated. For example, even if the high voltage electrical energy storage device is in a sleep mode, the thermal runaway detection sensors can still be operative.

Optionally in some examples, including in at least one preferred example, the first condition may be one of that the vehicle ignition is off, or the high voltage electrical energy storage device is in an at least partly in-active mode, and the second condition is that the energy level in the low voltage electrical energy storage device is below a set limit, wherein the method may comprise: when determining that the vehicle ignition is off, or the high voltage electrical energy storage device is in sleep mode, open the second switch and engage the first switch by processing circuitry, sense, by processing circuitry, the voltage level in the low voltage electrical energy storage device, and in response to that the energy level in the low voltage electrical energy storage device is below the set limit open the first switch and engage the second switch by processing circuitry. A technical benefit may include improved availability of the thermal runaway detection sensors despite the identified conditions that may otherwise reduce the operation capability of the availability thermal runaway detection sensors.

Optionally in some examples, including in at least one preferred example, the low voltage electrical energy storage is configured to supply a voltage in the range of 5-36V. This may be considered a low voltage electrical energy storage. Explicit examples include 12V and 24V electrical energy storages.

Optionally in some examples, including in at least one preferred example, the method may further comprise: receiving, by the processing circuitry, indications of thermal runaway events from separate internal processing circuitries of the high voltage electrical energy storage device. A technical benefit may include that receiving indications from separate processing circuitries provides improved redundancy for thermal runaway detection. Each of the separate internal processing circuitries may comprise integrated thermal runaway sensors.

Optionally in some examples, including in at least one preferred example, the internal processing circuitries are powered by the low voltage electrical energy storage via a second power line connected between the low voltage electrical energy storage and the internal processing circuitries. A technical benefit may include improved redundancy due to the separate second power line to the internal processing circuitry.

Optionally in some examples, including in at least one preferred example, each internal processing circuitry may be selectively powered by the low voltage electrical energy storage and/or the high voltage electrical energy storage device. Hereby, improved redundancy for powering the processing circuitries is provided.

There is further provided a computer program product comprising program code for performing, when executed by the processing circuitry, the method of the third aspect.

There is further provided a non-transitory computer-readable storage medium comprising instructions, which when executed by the processing circuitry, cause the processing circuitry to perform the method of the third aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of an electrical energy storage system according to an example.
**FIG. 2A** is an exemplary system diagram of an electrical energy storage system according to an example.
**FIG. 2B** is an exemplary system diagram of an electrical energy storage system according to an example.
**FIG. 3** is a flow chart of an exemplary method according to an example.
**FIG. 4** is a flow chart of an exemplary method according to an example.
**FIG. 5** is an exemplary system diagram of a computer system according to an example.
**FIG. 6** is a truck according to an exemplary vehicle.
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Thermal runaway detection requires suitable sensors and circuitry that are powered by an electric source. In electric vehicles a suitable power source is the high voltage electrical energy storage device also powering the electric propulsion machine of the vehicle. However, in some situations the high voltage electrical energy storage device may be unavailable, or it may be desirable to place the high voltage electrical energy storage device in an in-active mode. Unavailability may be for example due to low energy level in the high voltage electrical energy storage device or that other failures have occurred. Furthermore, it may desirable to avoid using the high voltage electrical energy storage device when it is not otherwise needed for its intended purpose.

In these situations, it is desirable to still power the thermal runaway detection system. Systems and methods that address this situation will now be discussed in more detail.

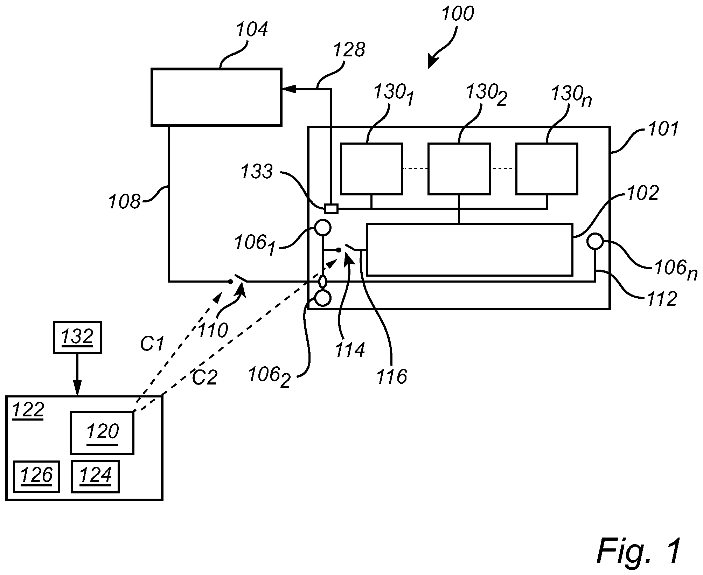

**FIG. 1** is an exemplary system diagram of an electrical energy storage system 100 comprising a high voltage electrical energy storage device 102 and a low voltage electrical energy storage device 104.

The high voltage electrical energy storage device 102 may be comprised in a high voltage electrical energy storage system 101. The high voltage electrical energy storage device 102 may be a traction electrical energy storage device 102 arranged to provide propulsion energy to an electric machine of an at least partly electrified vehicle, such as a fully electric vehicle or a hybrid electric vehicle. The high voltage electrical energy storage device 102 may be a Li-ion battery generating a voltage in the range of 400 V - 1kV depending on application. A typical nominal voltage is about 650V.

The high voltage electrical energy storage device 102 may comprise multiple electrical energy storage cells electrically connected in series and/or parallel and organized in several modules each comprising multiple cells.

The low voltage electrical energy storage device 104 may be a secondary or auxiliary electrical energy storage 104 that may power auxiliary devices of the vehicle.

The low voltage electrical energy storage 104 may be configured to supply a voltage in the range of 5-36V. For example, the low voltage electrical energy storage 104 may be a 12V battery or a 24V battery. The voltage of the low voltage electrical energy storage device 104 is lower than, or significantly lower than the voltage of the high voltage electrical energy storage device 102. For example, the voltage of the low voltage electrical energy storage device is less than 10% of the voltage of the high voltage electrical energy storage device 102.

The high voltage electrical energy storage system 101 comprises multiple thermal runaway detection sensors 106₁ to 106ₙ configured to detect thermal runaway events in cells or modules of the high voltage electrical energy storage device 102. There may be less sensors 106 than cells, or equal number of sensors 106 as cells.

Thermal runaway detection sensors 106₁ to 106ₙ may include temperature sensors, pressure sensors, gas sensors, volatile organic compound sensors that can detect leaking electrolyte, electric current sensors, voltage sensors from which measurements can be used for determining that a thermal event may occur.

The thermal runaway detection sensors 106₁ to 106ₙ are powered by the low voltage electrical energy storage 104. More specifically, the low voltage electrical energy storage 104 supplies power to the thermal runaway detection sensors 106₁ to 106ₙ via a first power supply line 108 and a first switch 110.

The first switch 110 is in the first power supply line 108 between the low voltage electrical energy storage device 104 and the thermal runaway detection sensors 106₁ to 106ₙ.

The thermal runaway detection sensors 106₁ to 106ₙ are connected to a power supply network or line 112. The first switch 110 is configured to close and open the electrical connection between the first power supply line 108 and the power supply network or line 112 of the thermal runaway detection sensors 106₁ to 106ₙ.

The electrical energy storage system 100 further comprises a second switch 114 in a power supply line 116 between the high voltage electrical energy storage device 102 and the thermal runaway detection sensors 106₁ to 106ₙ. The second switch 114 is configured to close and open the electrical connection between the second power supply line 116 and the power supply network or line 112 of the thermal runaway detection sensors 106₁ to 106ₙ.

When the first switch 110 is in an open state the electric connection between the low voltage electrical energy storage 104 and the thermal runaway detection sensors 106₁ to 106ₙ is broken and no electric power is provided from the low voltage electrical energy storage 104 to the thermal runaway detection sensors 106₁ to 106ₙ.

When the first switch 110 is in a closed or engaged state the electric connection between the low voltage electrical energy storage 104 and the thermal runaway detection sensors 106₁ to 106ₙ is complete and electric power can be provided from the low voltage electrical energy storage 104 to the thermal runaway detection sensors 106₁ to 106ₙ. In this state, the thermal runaway detection sensors 106₁ to 106ₙ are operational.

Similarly, when the second switch 114 is in an open state the electric connection between the high voltage electrical energy storage 102 and the thermal runaway detection sensors 106₁ to 106ₙ is broken and no electric power is provided from the high voltage electrical energy storage device 102 to the thermal runaway detection sensors 106₁ to 106ₙ through the first power supply line 108.

When the second switch 114 is in a closed or engaged state the electric connection between the high voltage electrical energy storage 102 and the thermal runaway detection sensors 106₁ to 106ₙ is complete and electric power can be provided from the high voltage electrical energy storage device 102 to the thermal runaway detection sensors 106₁ to 106ₙ.

The switches 110 and 114 may be semiconductor-based power switches or mechanical switches such as relays.

The electrical energy storage system 100 further comprises processing circuitry 120 configured to perform various steps. The processing circuitry 120 is comprised in a computer system 122 having access to computer program product 124 comprising program code for performing, when executed by the processing circuitry 120, the various steps. Furthermore, the computer system 122 may access a non-transitory computer-readable storage medium 126.

The electrical energy storage system 100 further comprises multiple separate internal processing circuitries 130₁ to 130ₙ. One of the multiple separate processing circuitries 130₁ to 130ₙ may be a master processing circuitry, or master ECU (electronic control unit) 130₁. The comprises multiple separate internal processing circuitries 130₁ to 130ₙ are internal to and comprised in the high voltage electrical energy storage system 101.

The processing circuitries 130₁ to 130ₙ are powered by the low voltage electrical energy storage 104 via a second power line 128 connected between the low voltage electrical energy storage 104 and the processing circuitries 130₁ to 130ₙ. That is, even if the high voltage electrical energy storage 102 is unavailable for powering the processing circuitries 130₁ to 130ₙ, the processing circuitries 130₁ to 130ₙ can receive electric energy from the low voltage electrical energy storage 104.

In some examples, the separate processing circuitries 130 include their own additional integrated thermal runaway sensors that can detect and provide indications of thermal runaway events independent of the thermal runaway detection sensors 106 arranged separate from the processing circuitries 130₁ to 130ₙ.

Each of the separate processing circuitries 130₁ to 130ₙ may be powered by the low voltage electrical energy storage 104 and/or the high voltage electrical energy storage 102 for redundancy. A switching circuitry 133 may be provided in the second power line 128 that is controllable to open and close the connection between the low voltage electrical energy storage 104 and the separate processing circuitries 130₁ to 130ₙ. For example, when the high voltage electrical energy storage 102 is not available the switching circuit 133 may be controlled to connect the low voltage electrical energy storage 104 to the separate processing circuitries 130₁ to 130ₙ.

The processing circuitry 120 is configured to control the state of the first switch 110 and the second switch 114 by respective control messages C1 and C2.

The processing circuitry 120 is configured to receive from vehicle subsystems 132, indications of conditions, or vehicle conditions to which the processing circuitry 120 may act to open or close the switches 110 and 114.

In response to a first condition, the processing circuitry 120 is configured to open the second switch 114 and engage the first switch 110, whereby the thermal runaway detection sensors 106₁ to 106ₙ are powered by the low voltage electrical energy storage device 104.

In response to a second condition, the processing circuitry 120 is configured to open the first switch 110 and engage the second switch 114, whereby the thermal runaway detection sensors 106₁ to 106ₙ are powered by the high voltage electrical energy storage device 102.

The first condition may be that the vehicle ignition is off. The first condition may be that the high voltage electrical energy storage system 101 is in an at least partly in-active mode, such as a sleep mode. When the high voltage electrical energy storage system 101 is in the at least partly in-active mode, the processing circuitries 130 and the electrical energy storage device 102 may be inactive but the the thermal runaway detection sensors 106₁ to 106ₙ are operational when powered by the low voltage electrical energy storage device 104.

The second condition may be that the energy level in the low voltage electrical energy storage device 104 is below a set limit. The limit may be at which the low voltage electrical energy storage device 104 needs charging. Purely as examples, the set limit may be 80%, 70%, 60%, 50%, or 40%, of a nominal voltage at a fully charged state.

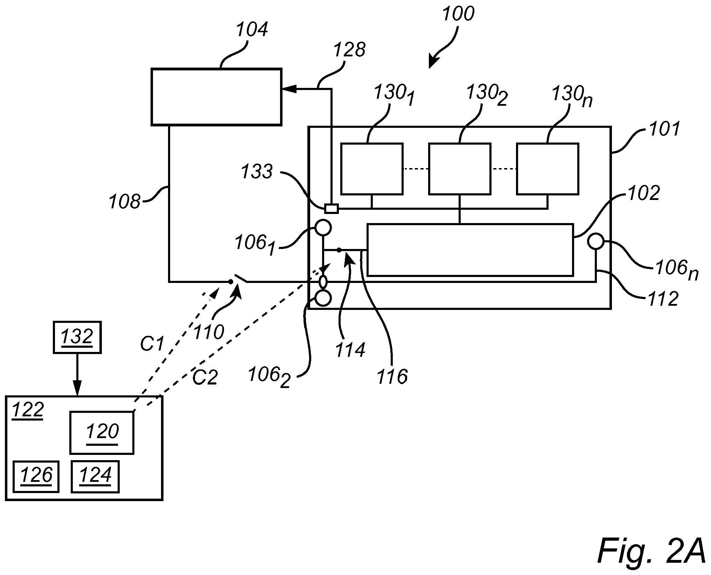

**FIG. 2A** is a diagram of the system 100 in a first state.

When the processing circuitry 120 has determined that, by receiving a message from the subsystem 132, the vehicle ignition is off, or the high voltage electrical energy storage device is in sleep mode, the processing circuitry 120 opens the second switch 114 and engages the first switch 110. In other words, the thermal runaway detection sensors 106₁ to 106ₙ are powered by the low voltage electrical energy storage device 104.

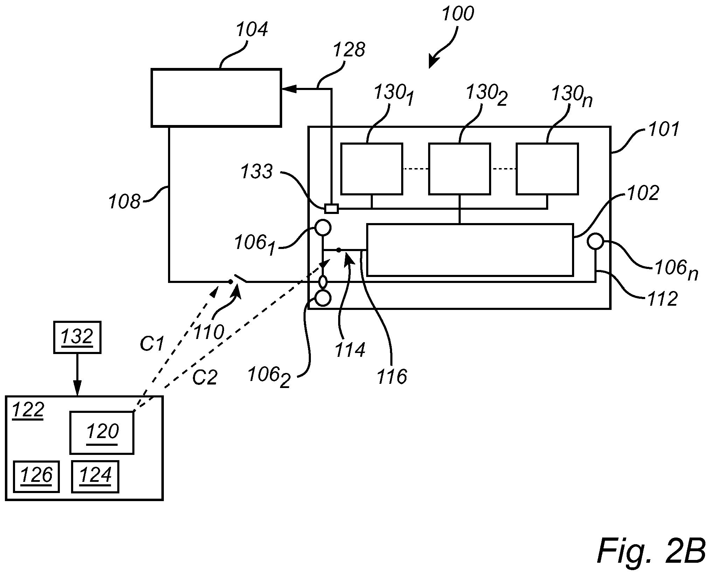

**FIG. 2B** is a diagram of the system 100 in a second state. The processing circuitry 120 is configured to sense the voltage level in the low voltage electrical energy storage device 104. In response to that the energy level in the low voltage electrical energy storage device 104 is below the set limit, the processing circuitry opens the first switch 110 and engage the second switch 114. That is, the thermal runaway detection sensors 106₁ to 106ₙ are powered by the high voltage electrical energy storage device 102.

The processing circuitry 120 is further configured to receive additional indications of thermal runaway events from the separate processing circuitries 130₁ to 130ₙ detected by integrated thermal runaway sensors of the processing circuitries 130₁ to 130ₙ.

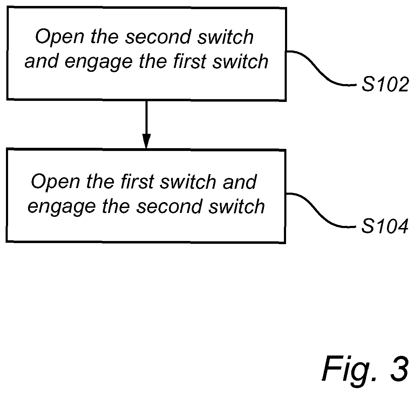

**FIG. 3** is a flow chart of a computer-implemented method for thermal runway detection in an energy storage system 100 comprising a high voltage electrical energy storage device 102 and a low voltage electrical energy storage device 104, according to an example. The electrical energy storage system 101 further comprises thermal runaway detection sensors 106₁ to 106ₙ configured to detect thermal runaway events in cells or modules of the high voltage electrical energy storage device 102. The low voltage electrical energy storage 104 supplying power to the thermal runaway detection sensors via a first power supply line 108. A first switch 110 is arranged in the first power supply line 108 between the low voltage electrical energy storage device and the thermal runaway detection sensors, and a second switch 114 is located in a power supply line 116 between the high voltage electrical energy storage device 102 and the thermal runaway detection sensors 106₁ to 106ₙ.

The method comprising, in response to a first condition, by processing circuitry 120 of a computer system, open in step S102 the second switch and engage the first switch, whereby the thermal runaway detection sensors are powered by the low voltage electrical energy storage device.

In response to a second condition, by the processing circuitry, open in step S104 the first switch and engage the second switch, whereby the thermal runaway detection sensors are powered by the high voltage electrical energy storage device.

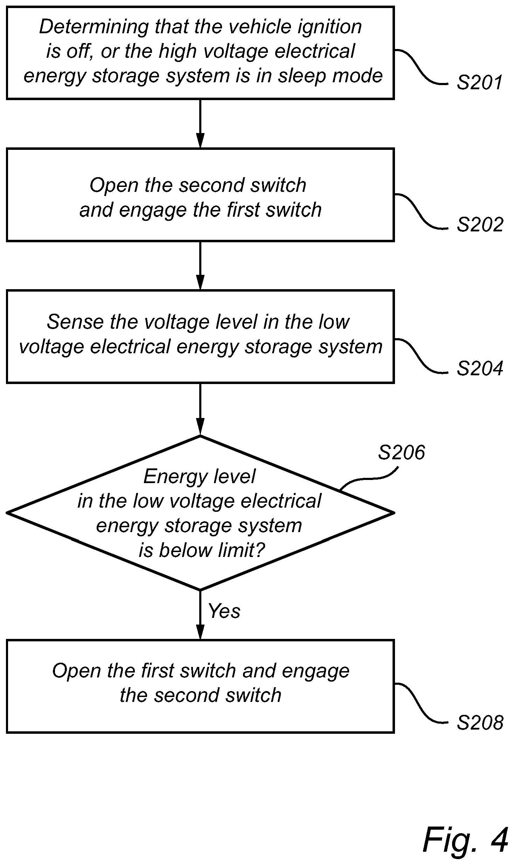

**FIG. 4** is a flow chart of a computer-implemented method for thermal runway detection in an energy storage system 100. In this example, the first condition is one of that the vehicle ignition is off, or the high voltage electrical energy storage device 102 or the internal processing circuities 130 are in an at least partly in-active mode. The second condition is that the energy level in the low voltage electrical energy storage device 104 is below a set limit.

The method comprises, in step S201, determining that the vehicle ignition is off, or the high voltage electrical energy storage device is in sleep mode.

In step S202, open the second switch 114 and engage the first switch 110.

In step S204, sense, by the processing circuitry, the voltage level in the low voltage electrical energy storage device 104.

In response to that the energy level in the low voltage electrical energy storage device 104 is below the set limit, open in step S208, the first switch 110 and engage the second switch 114 by the processing circuitry 120.

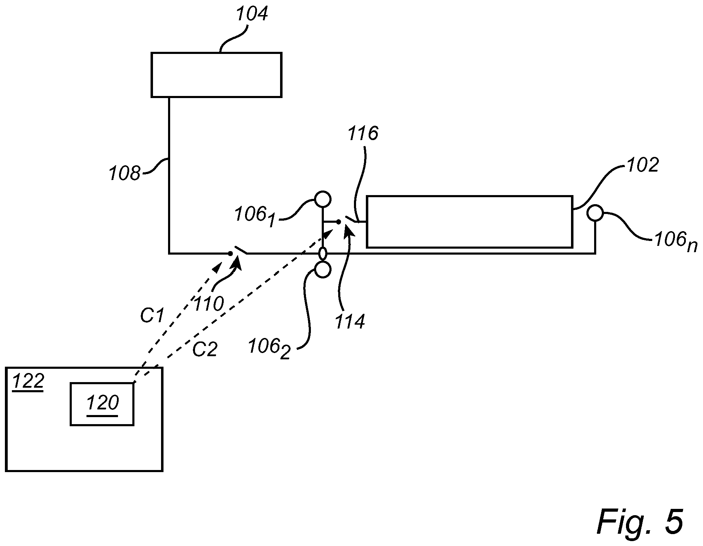

**FIG. 5** is another view of the computer system in **FIG. 1****,** according to an example. A computer system 122 for thermal runway detection in an electrical energy storage device 100 comprising: a high voltage electrical energy storage device 102, a low voltage electrical energy storage device 104, thermal runaway detection sensors 106₁ to 106ₙ configured to detect thermal runaway events in cells or modules of the high voltage electrical energy storage device 102, the low voltage electrical energy storage 104 supplying power to the thermal runaway detection sensors 106₁ to 106ₙ via a first power supply line 108, a first switch 110 in the first power supply line 108 between the low voltage electrical energy storage device 104 and the thermal runaway detection sensors 106₁ to 106ₙ, a second switch 114 in a power supply line 116 between the high voltage electrical energy storage device 102 and the thermal runaway detection sensors 106₁ to 106ₙ, the computer system comprising processing circuitry 120 configured to: in response to a first condition, open the second switch 114 and engage the first switch 110, whereby the thermal runaway detection sensors are powered by the low voltage electrical energy storage device, and in response to a second condition, open the first switch 110 and engage the second switch 114, whereby the thermal runaway detection sensors 106₁ to 106ₙ are powered by the high voltage electrical energy storage device 102.

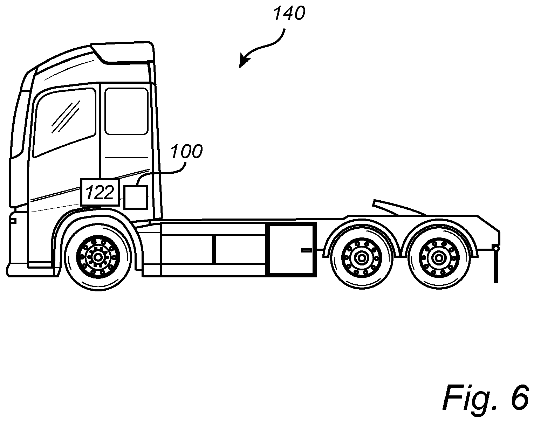

**FIG. 6** is example vehicle 140 according to examples of the present disclosure. The vehicle 140 is here shown as a heavy-duty truck but other types of vehicles are also applicable. The vehicle 140 comprises the computer system 122 and the electrical energy storage system 100. The vehicle 140 may be comprise a hybrid-, or fully electric driveline.

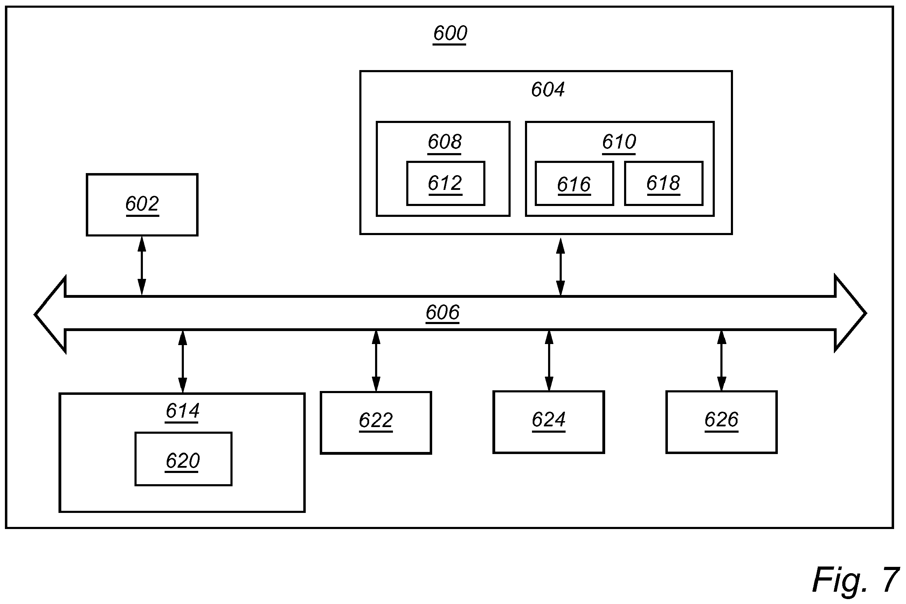

**FIG. 7** is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604,** and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface 626 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: a computer system for thermal runway detection in an electrical energy storage device comprising: a high voltage electrical energy storage device,
a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, the computer system comprising processing circuitry configured to: in response to a first condition, open the second switch and engage the first switch, whereby the thermal runaway detection sensors are powered by the low voltage electrical energy storage device, and in response to a second condition, open the first switch and engage the second switch, whereby the thermal runaway detection sensors are powered by the high voltage electrical energy storage device.

Example: 2 the computer system of example 1, wherein the first condition is one of that the vehicle ignition is off, or the high voltage electrical energy storage device is in an at least partly in-active mode and the second condition is that the energy level in the low voltage electrical energy storage device is below a set limit, wherein the processing circuitry is further configured to: when determining that the vehicle ignition is off, or the high voltage electrical energy storage device is in sleep mode, open the second switch and engage the first switch, sense the voltage level in the low voltage electrical energy storage device, and in response to that the energy level in the low voltage electrical energy storage device is below the set limit open the first switch and engage the second switch.

Example 3: The computer system of any of examples 1-2, wherein the low voltage electrical energy storage is configured to supply a voltage in the range of 5-36V.

Example 4: The computer system of any one of examples 1-3, the processing circuitry being a main processing circuitry, wherein the electrical energy storage device being part of an electrical energy storage system comprising multiple internal processing circuitries that each comprises integrated thermal runway sensors, wherein the main processing circuitry is configured to receive additional indications of thermal runaway events from the separate processing circuitries detected by the integrated thermal runaway sensors.

Example 5: the computer system of example 4, wherein the multiple internal processing circuitries of the high voltage electrical energy storage system is powered by the low voltage electrical energy storage via a second power line connected between the low voltage electrical energy storage and the processing circuitry of the electrical energy storage system.

Example 6: the computer system of any of examples 4-5, wherein each of the internal processing circuitry is selectively powered by the low voltage electrical energy storage or the high voltage electrical energy storage device.

Example 7: The computer system of example 6, comprising a switching circuitry configured to switch power source for the internal processing circuitry depending on a present availability of the low voltage electrical energy storage or the high voltage electrical energy storage device.

Example 8: A vehicle comprising the computer system of any of examples 1-7.

Example 9: The vehicle of example 8, further comprising: the thermal runaway detection sensors configured to detect thermal runaway events in cells or modules of the high voltage electrical energy storage device, the low voltage electrical energy storage supplying power to the thermal runaway detection sensors via a first power supply line, the first switch in the first power supply line between the low voltage electrical energy storage device and the thermal runaway detection sensors, and the second switch in a power supply line between the high voltage electrical energy storage device and the thermal runaway detection sensors.

Example 10: an electrical energy storage system comprising: a high voltage electrical energy storage device, a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, and processing circuitry configured to: in response to a first condition, open the second switch and engage the first switch, whereby the thermal runaway detection sensors are powered by the low voltage electrical energy storage device, and in response to a second condition, open the first switch and engage the second switch, whereby the thermal runaway detection sensors are powered by the high voltage electrical energy storage device.

Example 11: the electrical energy storage system of example 10, wherein the first condition is one of that the vehicle ignition is off, or the high voltage electrical energy storage device is in an at least partly in-active mode and the second condition is that the energy level in the low voltage electrical energy storage device is below a set limit, wherein the processing circuitry is further configured to: when determining that the vehicle ignition is off, or the high voltage electrical energy storage device is in sleep mode, open the second switch and engage the first switch, sense the voltage level in the low voltage electrical energy storage device, and in response to that the energy level in the low voltage electrical energy storage device is below the set limit open the first switch and engage the second switch.

Example 12: a computer-implemented method for thermal runway detection in an electrical energy storage device comprising: a high voltage electrical energy storage device, a low voltage electrical energy storage device, thermal runaway detection sensors configured to detect thermal runaway events in cells or modules of the high voltage electrical energy storage device, the low voltage electrical energy storage supplying power to the thermal runaway detection sensors via a first power supply line, a first switch in the first power supply line between the low voltage electrical energy storage device and the thermal runaway detection sensors, a second switch in a power supply line between the high voltage electrical energy storage device and the thermal runaway detection sensors, the method comprising: in response to a first condition, by processing circuitry of a computer system, opening the second switch and engaging the first switch, whereby the thermal runaway detection sensors are powered by the low voltage electrical energy storage device, an in response to a second condition, by the processing circuitry, opening the first switch and engaging the second switch, whereby the thermal runaway detection sensors are powered by the high voltage electrical energy storage device.

Example 13: the method of example 12, wherein the first condition is one of that the vehicle ignition is off, or the high voltage electrical energy storage device is in an at least partly in-active mode and the second condition is that the energy level in the low voltage electrical energy storage device is below a set limit, wherein the method comprises: when it is determined that the vehicle ignition is off, or the high voltage electrical energy storage device is in sleep mode, opening the second switch and engage the first switch by processing circuitry, sensing, by processing circuitry, the voltage level in the low voltage electrical energy storage device, and in response to that the energy level in the low voltage electrical energy storage device is below the set limit opening the first switch and engaging the second switch by processing circuitry.

Example 14: the method of any of examples 12-13, wherein the low voltage electrical energy storage is configured to supply a voltage in the range of 5-36V.

Example 15: the method of any of examples 12-14, wherein the method further comprises: receiving, by the processing circuitry, indications of thermal runaway events from separate internal processing circuitries of an electrical energy storage system of the electrical energy storage device.

Example 16: the method of example 15, wherein the internal processing circuitries are powered by the low voltage electrical energy storage via a second power line connected between the low voltage electrical energy storage and the internal processing circuitries.

Example 17: the method of example 16, wherein each internal processing circuitry is selectively powered by the low voltage electrical energy storage or the high voltage electrical energy storage device.

Example 18: the method of any of examples 15-17, wherein each of the separate internal processing circuitries comprises integrated thermal runaway sensors.

Example 19: a computer program product comprising program code for performing, when executed by the processing circuitry, the method of any of examples 12-18.

Example 20: a non-transitory computer-readable storage medium comprising instructions, which when executed by the processing circuitry, cause the processing circuitry to perform the method of any of examples 12-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (122) for thermal runway detection in an electrical energy storage device (102) comprising:
a high voltage electrical energy storage device (102),
a low voltage electrical energy storage device (104),
thermal runaway detection sensors (106₁, 106ₙ) configured to detect thermal runaway events in cells or modules of the high voltage electrical energy storage device,
the low voltage electrical energy storage (104) supplying power to the thermal runaway detection sensors (106) via a first power supply line (108),
a first switch (110) in the first power supply line (108) between the low voltage electrical energy storage device (104) and the thermal runaway detection sensors (104),
a second switch (114) in a power supply line between the high voltage electrical energy storage device and the thermal runaway detection sensors,
the computer system comprising processing circuitry (120) configured to:
in response to a first condition, open the second switch (114) and engage the first switch (110), whereby the thermal runaway detection sensors (106) are powered by the low voltage electrical energy storage device (104), and
in response to a second condition, open the first switch (110) and engage the second switch (114), whereby the thermal runaway detection sensors are powered by the high voltage electrical energy storage device (102).

2. The computer system of claim 1, wherein the first condition is one of that the vehicle ignition is off, or the high voltage electrical energy storage device is in an at least partly in-active mode and the second condition is that the energy level in the low voltage electrical energy storage device is below a set limit, wherein the processing circuitry is further configured to:
when determining that the vehicle ignition is off, or the high voltage electrical energy storage device is in sleep mode, open the second switch and engage the first switch,
sense the voltage level in the low voltage electrical energy storage device, and
in response to that the energy level in the low voltage electrical energy storage device is below the set limit open the first switch and engage the second switch.

3. The computer system of any of claims 1-2, wherein the low voltage electrical energy storage (104) is configured to supply a voltage in the range of 5-36V.

4. The computer system of any one of claims 1-3, the processing circuitry being a main processing circuitry, wherein the electrical energy storage device being part of an electrical energy storage system (101) comprising multiple internal processing circuitries (130) that each comprises integrated thermal runway sensors, wherein the main processing circuitry (120) is configured to receive additional indications of thermal runaway events from the separate processing circuitries detected by the integrated thermal runaway sensors.

5. The computer system of claim 4, wherein the multiple internal processing circuitries of the high voltage electrical energy storage system is powered by the low voltage electrical energy storage (104) via a second power line (128) connected between the low voltage electrical energy storage and the processing circuitry (130) of the electrical energy storage system (101).

6. The computer system of any of claims 4-5, wherein each of the internal processing circuitry is selectively powered by the low voltage electrical energy storage or the high voltage electrical energy storage device.

7. The computer system of claim 6, comprising a switching circuitry configured to switch power source for the internal processing circuitry depending on a present availability of the low voltage electrical energy storage or the high voltage electrical energy storage device.

8. A vehicle (140) comprising the computer system of any of claims 1-7.

9. A computer-implemented method for thermal runway detection in an electrical energy storage device comprising:
a high voltage electrical energy storage device (102),
a low voltage electrical energy storage device (104),
thermal runaway detection sensors (106) configured to detect thermal runaway events in cells or modules of the high voltage electrical energy storage device,
the low voltage electrical energy storage supplying power to the thermal runaway detection sensors via a first power supply line (108),
a first switch (110) in the first power supply line between the low voltage electrical energy storage device and the thermal runaway detection sensors,
a second switch (114) in a power supply line between the high voltage electrical energy storage device and the thermal runaway detection sensors,
the method comprising:
in response to a first condition, by processing circuitry of a computer system, opening the second switch and engaging the first switch (S102), whereby the thermal runaway detection sensors are powered by the low voltage electrical energy storage device, and
in response to a second condition, by the processing circuitry, opening the first switch and engaging the second switch (S104), whereby the thermal runaway detection sensors are powered by the high voltage electrical energy storage device.

10. The method of claim 9, wherein the first condition is one of that the vehicle ignition is off, or the high voltage electrical energy storage device is in an at least partly in-active mode and the second condition is that the energy level in the low voltage electrical energy storage device is below a set limit, wherein the method comprises:
when determining (S201) that the vehicle ignition is off, or the high voltage electrical energy storage device is in sleep mode, opening (S202) the second switch and engage the first switch by processing circuitry,
sensing (S204), by processing circuitry, the voltage level in the low voltage electrical energy storage device, and
in response to that the energy level in the low voltage electrical energy storage device is below the set limit opening the first switch and engaging (S208) the second switch by processing circuitry.

11. The method of any of claims 9-10, wherein the method further comprises:
receiving, by the processing circuitry, indications of thermal runaway events from separate internal processing circuitries (130) of an electrical energy storage system of the electrical energy storage device.

12. The method of claim 11, wherein the internal processing circuitries are powered by the low voltage electrical energy storage via a second power line connected between the low voltage electrical energy storage and the internal processing circuitries.

13. The method of claim 12, wherein each internal processing circuitry is selectively powered by the low voltage electrical energy storage or the high voltage electrical energy storage device.

14. A computer program product (124) comprising program code for performing, when executed by the processing circuitry, the method of any of claims 9-13.

15. A non-transitory computer-readable storage medium (126) comprising instructions, which when executed by the processing circuitry, cause the processing circuitry to perform the method of any of claims 9-13.
